**Europäisches Patentamt**

**European Patent Office**

**Office européen des brevets**

(19)

(11) Veröffentlichungsnummer: **0 141 059**
**B1**

(12)

# EUROPÄISCHE PATENTSCHRIFT

(45) Veröffentlichungstag der Patentschrift:
08.11.89

(21) Anmeldenummer: 84108959.2

(22) Anmeldetag: 28.07.84

(51) Int. Cl.⁴: **G 01 N 24/14, H 01 J 49/38**

(54) Verfahren zur Aufnahme von Ionen-Zyklotron-Resonanz-Spektren und Vorrichtung zur Durchführung des Verfahrens.

(30) Priorität: 30.08.83 DE 3331136

(43) Veröffentlichungstag der Anmeldung:
15.05.85 Patentblatt 85/20

(45) Bekanntmachung des Hinweises auf die Patenterteilung:
08.11.89 Patentblatt 89/45

(84) Benannte Vertragsstaaten:
CH DE FR GB LI

(56) Entgegenhaltungen:
FR-A- 2 508 172
US-A- 3 502 867
US-A- 3 535 512

MESSTECHNIK, Band 78, Nr. 6, Juni 1970, Seiten
109-115, München, DE; K.-H. LEBERT:
"Ionen-Cyclotronresonanz zur Untersuchung von
Ion-Molekül-Reaktionen"
INTERNATIONAL JOURNAL OF MASS SPECTROSCOPY
AND ION PHYSICS, Band 52, Nr. 1, August 1983, Seiten
1-24, Elsevier Science Publishers B.V., Amsterdam, NI;
P.R. KEMPER u.a.: "An improved tandem mass
spectrometer-ion-cyclotron-resonance spectrometer"

(73) Patentinhaber: Spectrospin AG, Industriestrasse 26,
CH-8117 Zürich-Fällanden (CH)

(72) Erfinder: Kellerhals, Hanspeter, Dr.,
Hegetsbergstrasse 6, CH-8610 Uster (CH)
Erfinder: Allemann, Martin, Dr., Walderstrasse 7,
CH-8340 Hinwil (CH)

(74) Vertreter: Patentanwälte Kohler - Schwindling - Späth,
Hohentwielstrasse 41, D-7000 Stuttgart 1 (DE)

## Beschreibung

Die Erfindung geht aus von einem Verfahren zur Aufnahme von Ionen-Cyklotron-Resonanz-Spektren nach dem Oberbegriff des Anspruchs 1.

Ein solches Verfahren ist beispielsweise aus der DE-A1-3 124 465 bekannt.

Bei der ICR-Spektroskopie, die man als einen Sonderfall der Massenspektroskopie bezeichnen könnte, besteht ein allgemeines Problem darin, gasförmige Ionen aus den zu untersuchenden Molekülen einer Substanzprobe zu erzeugen. Diese gasförmigen Ionen werden benötigt, weil sie bei der ICR-Spektroskopie in Resonanz gebracht werden.

Bei der Erzeugung dieser gasförmigen Ionen wird einmal ein hoher Wirkungsgrad und zum anderen ein möglichst schonender Prozeß der Erzeugung angestrebt. Ein hoher Wirkungsgrad führt zu einer hohen Ionenausbeute und damit zu einem hohen Meßsignal bzw. einer hohen Empfindlichkeit der verwendeten Apparatur. Die Forderung eines möglichst schonenden Prozeßes bedeutet, daß die Moleküle möglichst intakt und chemisch möglichst unverändert in einen geladenen Zustand überführt werden sollen. Hinsichtlich dieser beiden Forderungen treten besondere Schwierigkeiten dann auf, wenn die Probensubstanz schwerflüchtig und fest ist.

Von der klassischen Massenspektroskopie, bei der bekanntlich die Ionen linear und nicht wie bei der ICR-Spektroskopie kreisbahnförmig beschleunigt werden, sind mehrere Verfahren bekannt, um den genannten Forderungen bei der Erzeugung von gasförmigen Ionen gerecht zu werden.

Bei der chemischen Ionisation (CI) werden sehr reaktive Primärionen chemisch mit den zu untersuchenden, bereits gasförmigen Molekülen der Probensubstanz in Wechselwirkung gebracht. Dieses Verfahren ist zwar sehr schonend, hat jedoch den Nachteil, daß die zu untersuchende Probensubstanz zunächst verdampft werden muß, was den Anwendungsbereich entscheidend eingrenzt.

Bei der direkten chemischen Ionisation (DCI) werden ebenfalls Primärionen, wie bei der chemischen Ionisation, eingesetzt, die aber in diesem Falle direkt auf eine feste Probensubstanz einwirken. Der Nachteil dieses bekannten Verfahrens ist jedoch seine sehr geringe Ausbeute.

Bei der Laser Desorption wird eine feste Probensubstanz direkt bei hoher Energiedichte mit Laserlicht bestrahlt. Das Verfahren erfüllt in vielen Anwendungsbereichen die Forderung nach guter Ausbeute für intakte Molekülionen. Nachteil dieses Verfahrens ist jedoch, daß ein beträchtlicher apparativer Aufwand getrieben werden muß.

Bei dem Verfahren der Field Desorption (FD) werden Moleküle der Probensubstanz auf speziell gefertigten Elektroden extrem hohen elektrischen Feldstärken ausgesetzt, so daß ein Teil dieser Moleküle als Ionen emmittiert wird. Dieses Verfahren hat jedoch den Nachteil, daß es außerordentlich kompliziert auszuführen ist, so daß es nur von Personen mit beträchtlicher experimenteller Erfahrung und Geschick angewendet werden kann. Auch ist es erforderlich, zunächst Spezialelektroden herzustellen und die Probe in geeigneter Weise vorzubereiten.

Schließlich ist noch das Verfahren des Fast Atom Bombardment (FAB) bekannt, bei dem die Probe mit linear beschleunigten energiereichen Edelgasatomen (oder -ionen) beschossen wird. Im allgemeinen wird die Probensubstanz dabei zunächst in einer Glyzerinmatrix gelöst, damit durch Diffusion im Vakuum die Oberflächen ständig regeneriert werden, d.h. an der Oberfläche immer Moleküle der Probensubstanz vorhanden sind. Man kann die zu untersuchenden Probensubstanzen jedoch auch in geeigneter Form auf Metalloberflächen aufbringen, wie dies von A. Benninghofen und W. Sichtermann in der US-Z-Appl. Phys. 11, Seite 35, 1976 beschrieben wurde. Die Energie der auf die Probensubstanz auftreffenden Moleküle liegt dabei üblicherweise im Bereich 5000–10 000eV.

Die vorstehend beschriebenen, aus der Massenspektroskopie bekannten Verfahren lassen sich im Prinzip auch bei der ICR-Spektroskopie anwenden, wenn Ionen schwerflüchtiger, komplexer Probensubstanzen erzeugt werden müssen. Die bei den Verfahren im einzelnen beschriebenen Nachteile fallen jedoch bei der ICR-Spektroskopie noch wesentlich stärker ins Gewicht, weil alle zusätzlichen apparativen Einrichtungen unter Ultrahochvakuum-Bedingungen arbeiten müssen, d.h. unter Vakuumbedingungen, die einem um etwa zwei Größenordnungen tieferen Druck, verglichen mit der klassischen Massenspektroskopie, entsprechen.

Der Erfindung liegt daher die Aufgabe zugrunde, ein Verfahren der eingangs genannten Art dahingehend weiterzubilden, daß gasförmige Ionen auch von schwerflüchtigen und komplexen Probensubstanzen mit geringem apparativen Aufwand unter Ultrahochvakuum-Bedingungen der ICR-Spektroskopie erzeugt werden können.

Diese Aufgabe wird erfindungsgemäß durch die Merkmale des kennzeichnenden Teiles des Anspruches 1 gelöst.

Das erfindungsgemäße Verfahren hat damit den wesentlichen Vorteil, daß die Anregung der Primärionen auf dieselbe Weise erfolgt wie die Anregung der zu messenden Sekundärionen, so daß insoweit vergleichbare Versuchsbedingungen vorliegen.

Bevorzugt ist dabei eine Ausführungsform, bei der die Primärionen in unmittelbarer Nähe der Probensubstanz erzeugt werden und vorzugsweise Primär- und Sekundärionen in derselben Meßzelle mit derselben Resonanzapparatur angeregt werden. Auf diese Weise ergibt sich eine ganz beträchtliche Verminderung des apparativen Aufwandes, weil nur noch zusätzliche Mittel insoweit erforderlich sind, als die Primärionen zu erzeugen sind, während die Anregung der Primärionen auf das erforderliche Energieniveau mit denjenigen apparativen Mitteln durchgeführt werden kann, die zur nachfolgenden eigentlichen ICR-Messung ohnehin zur Verfügung stehen.

Bei einer bevorzugten Ausführungsform des erfindungsgemäßen Verfahrens werden die Primärionen aus einem Edelgas, vorzugsweise Argon, erzeugt. Es ist jedoch erfindungsgemäß auch möglich, anstelle eines Edelgases ein chemisch reaktives Gas zu verwenden.

Ein besonders einfacher Aufbau ergibt sich, wenn in weiterer Ausgestaltung der Erfindung die Primärionen in einer Meßzelle durch einen im Abstand von der Probensubstanz eingestrahlten Elektronenstrahl erzeugt werden und die Amplitude des Wechselfeldes für die ICR der Primärionen so eingestellt wird, daß sich eine Kreisbahn der Primärionen ergibt, die durch den Ort der Probensubstanz führt. In diesem Falle liegt der gesamte zusätzliche Aufwand darin, Mittel zum Erzeugen eines Elektronenstrahls vorzusehen, dessen Lage im Raum lediglich relativ zur Lage der Probensubstanz in einer Weise eingestellt werden muß, die den jeweiligen Meßbedingungen und den jeweils verwendeten Ionen angepaßt ist.

Um störende Wechselwirkungen zwischen den angeregten Primärionen und den zu messenden Sekundärionen auszuschalten, wird in weiterer Ausgestaltung der Erfindung vor Anregung der ICR ein Wechselfeld für die Primärionen eingestrahlt, dessen Amplitude so bemessen ist, daß die Primärionen zu einer Auffangelektrode gelangen, die vorzugsweise eine Masseelektrode ist. Auf diese Weise ist es möglich, die Meßzelle vor Aufnahme des eigentlichen ICR-Spektrums durch Einstrahlen eines einfachen Hochfrequenz-Impulses zu «reinigen», so daß die Primärionen selektiv entfernt werden. Diese selektive Entfernung der Primärteilchen ist deshalb erforderlich, weil bei Verwendung eines üblichen Quench-Impulses, bei dem die Ionenfalle kurzzeitig geöffnet wird, auch die gerade erzeugten Sekundärionen mit entfernt würden.

Zur Durchführung des erfindungsgemäßen Verfahrens wird eine Vorrichtung verwendet, wie sie im Anspruch 9 definiert ist.

Dabei ist weiter bevorzugt außerhalb der Meßzelle eine Anordnung zum Erzeugen eines Elektronenstrahles vorgesehen, der durch Öffnungen derart in die Meßzelle eingeleitet wird, daß seine Bahn in einem vorgewählten Abstand von dem Probenträger verläuft.

Eine besonders gute Wirkung wird erzielt, wenn die Meßzelle eine kreiszylindrische Gestalt hat, wobei vier zylindermantelsegmentförmige Flächen vorgesehen sind, die jeweils paarweise gegenüberstehend einen Sender bzw. einen Empfänger bilden und mit Masse gleichstromgekoppelt sind und ferner zwei Deckflächen als Ionenfallen mit einem endlichen Potential beschaltet sind. Diese Anordnung hat den Vorteil, daß durch die kreiszylindrische Gestalt der Meßzelle eine effektive Raumausnutzung in einer Solenoidspule erreicht wird, wie sie bei supraleitenden Magneten zum Erzeugen hoher Konstantmagnetfeldstärken verwendet wird. Das Einleiten des Elektronenstrahles bzw. das Einbringen der Probe in einer Richtung parallel zur Achse der Meßzelle entspricht dabei der Richtung besonders guter Zugänglichkeit des zu Meßzwecken nutzbaren Feldbereiches der Solenoidspule. Die Gleichstromkopplung der genannten Segmentflächen hat den Vorteil, daß bei der oben geschilderten starken Anregung der Primärionen unmittelbar vor Beginn des eigentlichen ICR-Experiments der Radius ihrer Kreisbahn so groß wird, daß die Primärionen in Kontakt zu den Sender- bzw. Empfängerflächen gelangen und durch deren Gleichstromkopplung mit Masse entfernt werden. Die Beschaltung der Deckflächen mit einem endlichen Potential erlaubt, je nach Polarität dieses Potentials positive bzw. negative Ionen in der Meßzelle zu fangen.

In weiterer Ausgestaltung der erfindungsgemäßen Vorrichtung ist der Probenträger an einer Schubstange befestigt, die sich parallel zur Achse der Meßzelle in dieser erstreckt und in radialer Richtung verschiebbar ist. Diese Anordnung hat den Vorteil, daß die Position des Probenträgers in radialer Richtung an die jeweiligen Meßbedingungen angepaßt werden kann. Da die Probensubstanz in der Umlaufbahn der Primärionen liegen muß, kann auf diese Weise eine einfache Anpassung an die jeweils verwendeten Primärionen, die Stärke des Magnetfeldes usw. bewirkt werden.

Weitere Vorteile ergeben sich aus der Beschreibung und der beigefügten Zeichnung.

Die Erfindung ist in der Zeichnung dargestellt und wird in der nachfolgenden Beschreibung näher erläutert. Es zeigen:

Fig. 1 eine schematische Darstellung zur Erläuterung der erzeugten Ionen-Zyklotron-Resonanz,

Fig. 2 eine perspektivische schematische Darstellung einer ICR-Meßzelle,

Fig. 3 ein Zeitdiagramm zur Erläuterung einer Ausführungsform einer erfindungsgemäßen Verfahrens, bei dem das ICR-Spektrum durch langsame Frequenzvariation angeregt wird,

Fig. 4 eine Darstellung entsprechend Fig. 3, jedoch mit Aufnahme des ICR-Spektrums in Fourier-Technik.

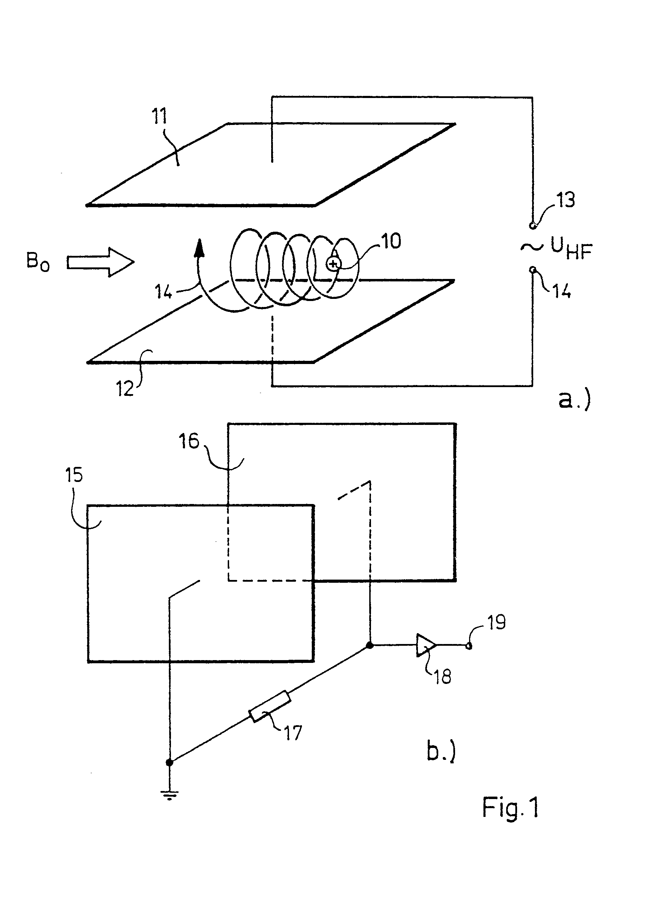

In Fig. 1a bezeichnet 10 ein Ion einer Probensubstanz. Das Ion 10 befindet sich zwischen zwei parallel zueinander angeordneten Platten 11, 12, die einen Hochfrequenz-Sender bilden. Hierzu sind die Platten 11, 12 mit Klemmen 13, 14 verbunden, an die eine Hochfrequenz-Spannung $U_{HF}$ anschließbar ist. Das Ion 10 befindet sich ferner unter dem Einfluß eines hohen Konstantmagnetfeldes $B_0$, dessen Richtung parallel zu den Flächen der Platten 11, 12 d.h., senkrecht zu dem sich dazwischen ausbildenden Wechselfeld aufgrund der Spannung $U_{HF}$ gerichtet ist. Bekanntlich bewegt sich ein geladenes Teilchen unter dem Einfluß eines konstanten Magnetfeldes auf einer gekrümmten Bahn. Hat das konstante Magnetfeld eine besonders hohe Feldstärke, ergibt sich eine Kreisbahn, deren Radius bei üblichen Ionen im Zentimeterbereich liegen kann. Wird nun senkrecht zum Konstantmagnetfeld ein elektrisches Wechselfeld angelegt, dessen Frequenz so bemessen ist, daß es der Umlauffrequenz des geladenen Teilchens entspricht, wird das geladene Teilchen angeregt, so daß sich der Radius der Kreisbahn vergrößert. Es ergibt sich damit eine Schraubenlinie, wie sie in Fig. 1a mit 14 angedeutet ist. Die anzulegende Resonanzfrequenz ist dabei ungefähr gleich dem Produkt aus der Ladung des geladenen Teilchens und der Stärke des Magnetfeldes, dividiert durch die Masse des Teilchens.

In der ICR-Spektroskopie wird nun jeweils ein ganzer Ionen-Verbund durch das genannte Hochfrequenz-Wechselfeld angeregt. Wird diese Anregung zu einem bestimmten Zeitpunkt abgeschaltet, kann ein ICR-Signal in Gestalt eines Stromes mit Hilfe zweier Platten 15, 16 gemessen werden, die senkrecht zu den Platten 11, 12 angeordnet sind. In der Zeichnung ist die Darstellung in den Fig. 1a und 1b nur der Übersichtlichkeit halber getrennt worden. Verbindet man die Empfängerplatten 15, 16 über einen Widerstand 17, der beispielsweise an einer Seite geerdet ist, kann an seinem anderen Anschluß über einen Verstärker 18 an einer Klemme 19 das ICR-Signal abgenommen werden.

Aus den Frequenzanteilen des gemessenen ICR-Signales können dann Massenzahlen ermittelt werden, die den in der Probensubstanz enthaltenen Ionen 10 zugeordnet sind.

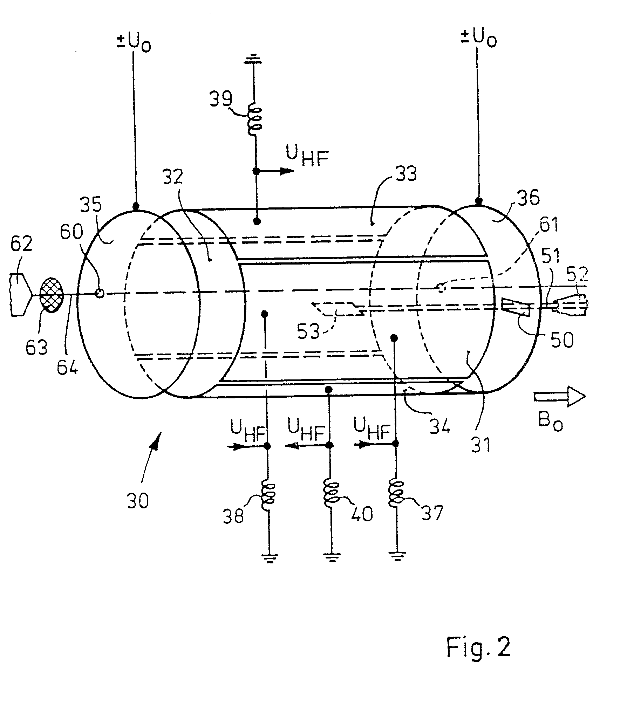

Eine besonders bevorzugte Ausführungsform einer Meßzelle, die zur Durchführung des erfindungsgemäßen Verfahrens geeignet ist, ist in Fig. 2 dargestellt. Diese Meßzelle 30 hat kreiszylinderförmige Gestalt, wobei die Zylindermantelfläche in vier Segmente unterteilt ist. Zum einen sind einander gegenüberliegende Senderflächen 31, 32 und zum anderen einander gegenüberliegende Empfängerflächen 33, 34 vorgesehen, deren Funktion derjenigen der Platten 11, 12, 15, 16 in Fig. 1 entspricht.

Die kreiszylinderförmige Meßzelle 30 gemäß Fig. 2 wird von kreisförmigen Deckflächen 35, 36 abgeschlossen.

Den Senderflächen 31, 32 kann, wie mit Pfeilen angedeutet, ein Sendersignal in Gestalt einer Hochfrequenzspannung $U_{HF}$ zugeführt werden. Von diesem Punkt der Senderzuführung nach Masse sind Induktivitäten 37, 38 geschaltet, so daß die Senderflächen 31, 32 mit Masse gleichstromgekoppelt sind. In entsprechender Weise kann eine Hochfrequenzspannung $U_{HF}$ an den Empfängerflächen 33, 34 abgenommen werden, wie ebenfalls mit Pfeilen angedeutet, wobei diese Empfängerflächen 33, 34 gleichfalls über Induktivitäten 39, 40 mit Masse gleichstromgekoppelt sind.

Die Deckflächen 35, 36 sind alternativ mit einem positiven Potential $+U_o$ oder einem negativen Potential $-U_o$ beschaltbar.

Die Meßzelle 30 bildet damit eine sogenannte Ionenfalle. Bei einer bestimmten wirksamen Stärke des Konstantmagnetfeldes $B_o$ ist der Radius der sich einstellenden Ionenbahnen in der Meßzelle 30 nämlich so gering, daß die Ionen nicht in Kontakt mit den Sender- bzw- Empfängerflächen 31 bis 34 kommen können, die mit Masse gleichstromgekoppelt sind. Bei positiven Ionen in der Meßzelle 30 sind die Deckflächen 35, 36 mit einem positiven Bezugspotential $+U_o$ beschaltet, so daß

die positiven Ionen von diesen Deckflächen 35, 36 abgestoßen werden. Bei sorgfältiger Aufrechterhaltung des in der Meßzelle 30 herrschenden Ultrahochvakuums können auf diese Weise Ionen über mehrere Stunden in der Meßzelle 30 eingeschlossen werden.

Zum Einführen einer Probensubstanz in die Meßzelle 30 ist in einer Deckfläche 36 ein radialer Schlitz 50 angeordnet, durch den eine Schubstange 51 mit Hilfe eines Griffes 52 geschoben werden kann. Am Ende der Schubstange 51 befindet sich ein Probenträger 53, auf den die zu untersuchende Probensubstanz aufgebracht wird. Die Achse der Schubstange 51 verläuft parallel zur Längsachse der Meßzelle 30, ist jedoch in einem endlichen Abstand von dieser angeordnet, der durch radiales Verschieben der Schubstange 51 im radialen Schlitz 50 einstellbar ist. Es versteht sich, daß die Anordnung der Elemente 50 bis 53 dabei nur schematisch zu verstehen ist, selbstverständlich können auch geeignete andere Vorrichtungen verwendet werden, die eine radiale Verschiebung eines Probenträgers in der Meßzelle 30 gestatten.

Weiterhin ist die Meßzelle 30 mit einem ionisierbaren Medium gefüllt, vorzugsweise mit einem Edelgas, beispielsweise Argon. Um in diesem ionisierbaren Medium Ionen zu erzeugen, sind in den Deckflächen 35, 36 miteinander fluchtende Öffnungen 60, 61 vorgesehen, durch die ein Elektronenstrahl 64 in das Innere der Meßzelle 30 geleitet werden kann. Der Ionenstrahl 64 wird in an sich bekannter Weise mit Hilfe eines Glühfadens 62 und einer Gitterelektrode 63 erzeugt, die sich in der Nähe der einen Öffnung 60 befinden. Der Elektronenstrahl 64 wird dabei ebenfalls parallel zur Achse der Meßzelle 30 in diese eingeleitet, jedoch ebenfalls in einem gewissen Abstand von dieser.

Zur Durchführung des erfindungsgemäßen Verfahrens wird zunächst über einen Gaseinlaß ein geeigneter Dampfdruck des ionisierbaren Gases, beispielsweise des Argons in der Meßzelle 30 eingestellt.

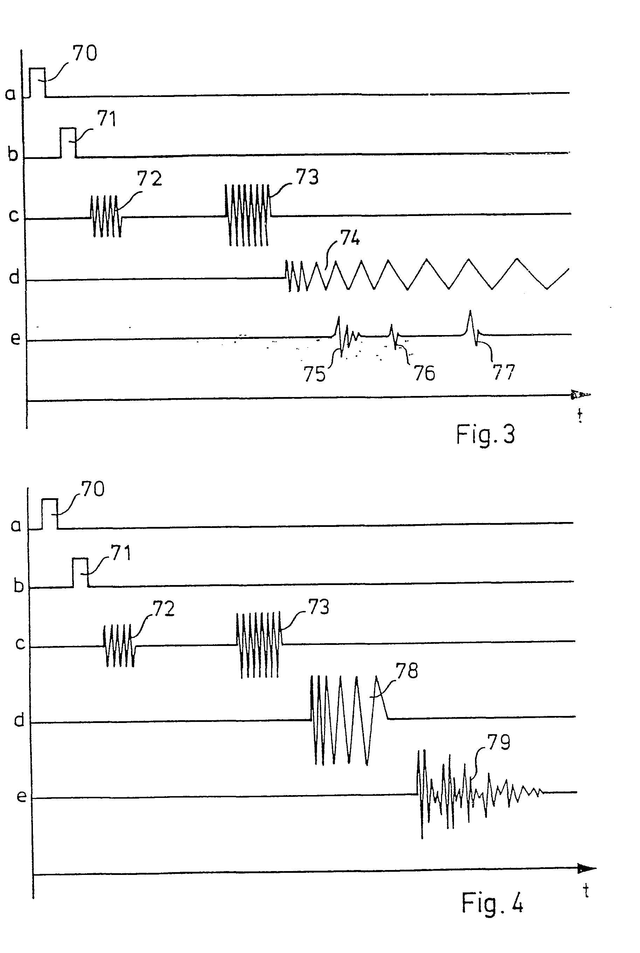

Die weiteren Verfahrensschritte sollen nun anhand der Zeitdiagramme der Fig. 3 und 4 erläutert werden.

Zunächst wird gemäß Fig. 3a ein sogenannter Quench-Impuls 70 eingestellt, der die Ionenfalle kurzzeitig öffnet und damit alle in der Meßzelle 30 noch vorhandenen Ionen entfernt. Beispielsweise können die die Meßzelle 30 begrenzenden Flächen hierzu kurzzeitig mit einem Potential geeigneter Polarität beschaltet werden.

Nach Abschalten des Quench-Impulses 70 wird, wie aus Fig. 3b ersichtlich, ein Impuls 71 erzeugt, der kurzzeitig für die Erzeugung des Elektronenstrahles 64 sorgt. Der Ionenstrahl 64 bewirkt, daß längs seiner Bahn in der Meßzelle 30 in dem dort enthaltenen ionisierbaren Argon Ionen erzeugt werden. Diese Ionen haben jedoch zunächst noch ein relativ niedriges Energieniveau. Um diese Primärionen des Argons anzuregen, wird nachfolgend, wie man aus Fig. 3c erkennt, eine erste Wechselfeld-Anregung 72 für die Primärionen eingestrahlt. Die Frequenz dieser Anregung 72 ist dabei so bemessen, daß sie der eingangs erläuterten Umlauffrequenz der Primärionen entspricht. Amplitude und Dauer der Anregung 72 sind hingegen so bemessen, daß die Primärionen sich auf einer definierten Kreisbahn innerhalb der Meßzelle 30 bewegen. Der Radius dieser Kreisbahn ist dabei so festgelegt, daß die angeregten und nunmehr energiereichen Primärionen auf die Probensubstanz im Bereich des Probenträgers 53 auftreffen, so daß Sekundärionen in der Probensubstanz erzeugt werden. Da sich dieser Vorgang innerhalb eines sehr kompakten Volumens abspielt und die Erzeugung der Primärionen, deren Anregung und die Erzeugung der Sekundärionen unmittelbar zeitlich aufeinanderfolgt, ist die Erzeugung der Sekundärionen dadurch einmal von beträchtlicher Ausbeute, andererseits jedoch auch hinreichend schonend, so daß keine chemische Veränderung der erzeugten Sekundärionen eintritt.

Nachdem die Erzeugung der Sekundärionen durch Auftreffen der angeregten Primärionen auf die Probensubstanz abgeschlossen ist, wird eine zweite Wechselfeld-Anregung 73 eingestrahlt, wie man dies in Fig. 3c erkennt. Diese zweite Anregung 73 hat eine wesentlich größere Amplitude als die erste Anregung 72, so daß der Radius der Umlaufbahn der Primärionen hierdurch stark vergrößert wird. Die Primärionen geraten hierdurch in Kontakt mit den zylindermantelsegmentförmigen Flächen 31 und 34 von Sender und Empfänger und werden durch deren Gleichstromkopplung über die Induktivitäten 37 bis 40 entfernt. Das Innere der Meßzelle 30 ist nunmehr vollkommen frei von Ionen, die nicht von der Probensubstanz herrühren.

Gemäß der in Fig. 3 dargestellten Variante eines erfindungsgemäßen Verfahrens wird nun, wie man in Fig. 3d erkennt, eine Wechselfeldanregung 74 für die Sekundärelektronen eingestrahlt, deren Frequenz zeitvariant ist. Hierdurch wird das ICR-Spektrum in einem Frequenzdurchgang abgetastet, so daß nacheinander ICR-Signale 75, 76, 77 auftreten, die der jeweils eingestrahlten Frequenz der Wechselfeldanregung 74 entsprechen. Die ICR-Signale 75, 76, 77 sind aus Fig. 3e zu ersehen. Es versteht sich, daß der in Fig. 3d dargestellte Frequenzdurchlauf durch die Anregung 74 auch mehrfach nacheinander durchgeführt werden kann, wobei die erhaltenen ICR-Signale 75 bis 77 in einem Speicher akkumuliert und das Signal/Rausch-Verhältnis durch Mittelwertbildung erhöht wird.

Bei der in Fig. 4 dargestellten Variante eines erfindungsgemäßen Verfahrens sind zwar die in Fig. 4a bis 4c dargestellten Verfahrensschritte identisch mit denjenigen aus Fig. 3a bis c, anstelle der Wechselfeldanregung 74 mit sich langsam ändernder Frequenz gemäß Fig. 3d wird beim Verfahren gemäß Fig. 4d jedoch eine Anregung 78 in Form eines Fourier-Signales eingestrahlt. Dabei werden in einem vorgegebenen begrenzten Frequenzbereich gleichzeitig sämtliche Frequenzen eingestrahlt und damit alle in diesem Bereich liegenden Resonanzen angeregt. Nach Abschalten der Fourier-Anregung 78 ergibt sich dann im Empfänger ein Interferogramm 79, wie es in Fig. 4e dargestellt ist. Dieses Interferogramm 79 entspricht dem zeitlichen Abklingen der mit unterschiedlichen Frequenzen angeregten Resonanzvorgänge. Das Interferogramm 79, das sämtliche spektralen Komponenten im Zeitbereich enthält, wird mit Hilfe bekannter Verfahren der Fourier-Transformation in den Frequenzbereich umgerechnet, so daß ein Frequenzspektrum entsteht, wie dies Fig. 3e bereits zeigt.

Der Vorteil des Fourier-Verfahrens liegt jedoch darin, daß in derselben Meßzeit eine wesentlich höhere Signalausbeute erzielt werden kann. Anstatt nämlich die Frequenzen des Spektrums langsam nacheinander abzutasten, wozu eine bestimmte Meßzeit benötigt wird, können zahlreiche Fourier-Anregungen 78 nacheinander eingestrahlt werden, mit denen jeweils das gesamte Spektrum angeregt wird. Nach jeder eingestrahlten Fourier-Anregung 78 kann jedoch ein separates Interferogramm 79 in einen Speicher eingeschrieben und dort aufaddiert werden, so daß mit der bereits erwähnten Methode der Mittelwertbildung ein hoher Signal/Rauschabstand erzielt werden kann.

In einem typischen Anwendungsfall beträgt die Länge der Meßzelle 30 ungefähr 6 cm, der Durchmesser ca. 5 cm. Die Stärke des Konstantmagnetfeldes $B_0$ beträgt bei Verwendung eines supraleitenden Magneten beispielsweise 4,7 T, was bei den üblichen Massenzahlen einer Anregungsfrequenz im Bereich von 10 MHz entspricht. Der in der Meßzelle herrschende Druck beträgt typischerweise $10^{-7}$ bis $10^{-9}$ mbar.

## Patentansprüche

1. Verfahren zur Aufnahme von Ionen-Cyklotron-Resonanz- oder kurz ICR-Spektren, bei dem eine schwerflüchtige Probensubstanz mit energiereichen Ionen, d.h. Primärionen, beschossen und dadurch Ionen dieser Probensubstanz, d.h. Sekundärionen, erzeugt werden, die dann in einem Ultrahochvakuum einem homogenen Konstantmagnetfeld sowie einem zum Magnetfeld senkrecht gerichteten elektrischen Wechselfeld vorgegebener Frequenz, d.h. ICR-Bedingungen, ausgesetzt werden, worauf von den durch das Wechselfeld in Resonanz gebrachten Ionen erzeugte Meßsignale registriert werden, dadurch gekennzeichnet, daß den Primärionen die zur Ionisierung der Probensubstanz erforderliche Energie durch Ionen-Cyklotron-Resonanz-Anregung erteilt wird.

2. Verfahren nach Anspruch 1, dadurch gekennzeichnet, daß Primärionen in unmittelbarer Nähe der Probensubstanz erzeugt werden.

3. Verfahren nach Anspruch 1 oder 2, dadurch gekennzeichnet, daß Primär- und Sekundärionen in derselben Meßzelle (30) mit derselben Resonanzapparatur (31, 32) angeregt werden.

4. Verfahren nach einem der Ansprüche 1 bis 3, dadurch gekennzeichnet, daß die Primärionen aus einem Edelgas, vorzugsweise Argon, erzeugt werden.

5. Verfahren nach einem der Ansprüche 1 bis 3, dadurch gekennzeichnet, daß die Primärionen aus einem chemisch reaktiven Gas erzeugt werden.

6. Verfahren nach einem der Ansprüche 1 bis 5, dadurch gekennzeichnet, daß Primärionen in der Meßzelle (30) durch einen im Abstand von der Probensubstanz eingestrahlten Elektronenstrahl (64) erzeugt werden und daß die Amplitude des Wechselfeldes (72) für die Ionen-Cyklotron-Resonanz der Primärionen so eingestellt wird, daß sich eine Kreisbahn der Primärionen ergibt, die durch den Ort (53) der Probensubstanz führt.

7. Verfahren nach Anspruch 6, dadurch gekennzeichnet, daß vor Anregung der Ionen-Cyklotron-Resonanz der Sekundärionen ein Wechselfeld (73) für die Primärionen eingestrahlt wird, dessen Amplitude so groß ist, daß die Primärionen zu einer Auffangelektrode gelangen.

8. Verfahren nach Anspruch 7, dadurch gekennzeichnet, daß die Auffangelektrode für Gleichstrom eine Masseelektrode (31, 32, 33, 34) ist.

9. Vorrichtung zur Durchführung des Verfahrens nach einem der vorhergehenden Ansprüche mit einer Einrichtung zum Erzeugen von energiereichen Primärionen und zum Beschießen einer schwerflüchtigen Probensubstanz mit diesen Primärionen zur Erzeugung von als Sekundärionen bezeichneten Ionen der Probensubstanz und mit einer Ionen-Cyklotron-Resonanz- oder kurz ICR-Meßzelle (30) und Mitteln zum Anregen und Messen der Resonanz der Sekundärionen, dadurch gekennzeichnet, daß die ICR-Meßzelle (30) ein die Primärionen bildendes Medium enthält, daß in der ICR-Meßzelle (30) ein Probenträger (53) für die schwerflüchtige Probensubstanz angeordnet ist und daß die Mittel zum Anregen und Messen der Resonanz der Sekundärionen auch zum Anregen der Resonanz der Primärionen ausgebildet sind, derart, daß auf dem Probenträger (53) angeordnete Probensubstanz von den in der ICR-Meßzelle zur Resonanz angeregten Primärionen getroffen und dadurch selbst ionisiert wird und die Resonanz der Sekundärionen unmittelbar in der ICR-Meßzelle meßbar ist.

10. Vorrichtung nach Anspruch 9, dadurch gekennzeichnet, daß außerhalb der Meßzelle (30) eine Anordnung (62, 63) zum Erzeugen eines Elektronenstrahles (64) vorgesehen ist, der durch Öffnungen (60, 61) derart in die Meßzelle (30) eingeleitet wird, daß seine Bahn in einem vorgewählten Abstand von dem Probenträger (53) verläuft.

11. Vorrichtung nach Anspruch 9 oder 10, dadurch gekennzeichnet, daß die Meßzelle (30) eine kreiszylindrische Gestalt hat, wobei vier zylindermantelsegmentförmige Flächen (31 bis 34) vorgesehen sind, die jeweils paarweise gegenüberstehend einen Sender (31, 32) bzw. einen Empfänger (33. 34) bilden und mit Masse gleichstromgekoppelt sind und ferner zwei Deckflächen (35, 36) als Ionenfallen mit einem endlichen Potential ($\pm U_o$) beschaltet sind.

12. Vorrichtung nach Anspruch 11, dadurch gekennzeichnet, daß der Probenträger (53) an einer Schubstange (51) befestigt ist, die sich parallel zur Achse der Meßzelle (30) in dieser erstreckt und in radialer Richtung verschiebbar ist.

13. Vorrichtung nach Anspruch 12, dadurch gekennzeichnet, daß der Elektronenstrahl (64) parallel zur Achse der Meßzelle (30) geleitet wird.

## Claims

1. Method of recording ion cyclotron resonance or, for short, ICR-spectra, in which a non-volatile sample substance is bombarded with high-energy ions, i.e. primary ions, and in this way ions of this sample substance i.e. secondary ions are generated, which are then exposed, in an ultrahigh vacuum, to a homogeneous constant magnetic field and to an alternating electrical field directed perpendicularly to the magnetic field, i.e. ICR conditions, after which measuring signals generated by the ions caused to resonate by the alternating field are recorded, characterised in that the energy necessary for ionising the sample substance is imparted to the primary ions by ion cyclotron resonance excitation.

2. Process according to claim 1, characterised in that primary ions are generated in the immediate vicinity of the sample substance.

3. Process according to claim 1 or 2, characterised in that primary and secondary ions are excited in the same measuring cell (30) with the same resonance apparatus (31, 32).

4. Process according to one of claims 1 to 3, characterised in that the primary ions are generated from a rare gas, preferably argon.

5. Process according to one of claims 1 to 3, characterised in that the primary ions are generated from a chemically reactive gas.

6. Process according to one of claims 1 to 5, characterised in that primary ions are generated in the measuring cell (30) by an electron beam shone in at a spacing from the sample substance and the amplitude of the alternating field (72) for the ion cyclotron resonance of the primary ions is adjusted so that the primary ions have a circular path which passes through the location (53) of the sample substance.

7. Process according to claim 6, characterised in that, before the ion cyclotron resonance of the secondary ions is excited, an alternating field (73) for the primary ions is irradiated, the amplitude of which is such that the primary ions reach a catching electrode.

8. Process according to claim 7, characterised in that the catching electrode for direct current is a ground electrode (31, 32, 33, 34).

9. Apparatus for performing the method according to one of the preceding claims, with means for generating high-energy primary ions for bombarding a non-volatile sample substance with these primary ions in order to generate ions of the sample substance, referred to as secondary ions, and with an ion cyclotron resonance or, for short, ICR measuring cell (30) and means for exciting and measuring the resonance of the secondary ions, characterised in that the ICR measuring cell (30) contains a medium which forms the primary ions, in that in the ICR measuring cell (30) is a sample carrier (53) for the non-volatile sample substance and in that means for exciting and measuring the resonance of the secondary ions are also adapted to excite the resonance of the primary ions, so that the sample substance located on the sample carrier (53) is hit by the primary ions set resonating in the ICR measuring cell and the sample substance is thus ionised itself and the resonance of the secondary ions is directly measurable in the ICR measuring cell.

10. Apparatus according to claim 9, characterised in that outside the measuring cell (30) is an arrangement (62, 63) for generating an electron beam (64) which is directed through openings (60, 61) into the measuring cell (30) in such a way that its path runs at a preselected distance from the sample carrier (53).

11. Apparatus according to claim 9 or 10, characterised in that measuring cell (30) is of circular-cylindrical configuration, having four surfaces (31 to 34) in the shape of segments of a cylinder surface, the pairs of said surfaces located opposite each other forming a transmitter (31, 32) and a receiver (33, 34), respectively, and being d.c.-coupled to the chassis and furthermore two covering surfaces (35, 36) are wired up as ion traps with a finite potential ($\pm U_0$).

12. Apparatus according to claim 11, characterised in that the sample carrier (53) is secured to a push rod (51) which extends inside the measuring cell (30) and parallel to the axis thereof and is movable in the radial direction.

13. Apparatus according to claim 12, characterised in that the electron beam (64) is directed parallel to the axis of the measuring cell (30).

Revendications

1. Procédé d'enregistrement de spectres de résonance cyclotron pour ions ou en abréviations spectres RCI dans lequel une substance d'échantillonnage difficilement transformable des ions riches en énergie, c'est-à-dire des ions primaires, et ainsi des ions de cette substance d'échantillonnage, c'est-à-dire des ions secondaires sont produits, qui sont ensuite exposés à un champ magnétique constant et homogène dans un vide ultra-élevé ainsi qu'à un champ électrique alternatif de fréquence prédéterminée qui est orienté perpendiculairement au champ magnétique, c'est-à-dire des conditions RCI, après quoi des signaux de mesure produits par les ions amenés en résonance par le champ alternatif sont enregistrés, caractérisé en ce que l'énergie nécessaire à l'ionisation de la substance d'échantillonnage est délivrée aux ions primaires par excitation par résonance-cyclotron pour ions.

2. Procédé suivant la revendication 1, caractérisé en ce que des ions primaires sont produits à proximité immédiate de la substance d'échantillonnage.

3. Procédé suivant les revendications 1 ou 2, caractérisé en ce que des ions primaires et secondaires sont excités dans la même cellule de mesure (30) par le même appareillage de résonance (31, 32).

4. Procédé suivant l'une des revendications 1 à 3, caractérisé en ce que les ions primaires sont produits à partir d'un gaz inerte, de préférence de l'Argon.

5. Procédé suivant l'une des revendications 1 à 3, caractérisé en ce que les ions primaires sont produits à partir d'un gaz réactif chimique.

6. Procédé suivant l'une des revendications 1 à 5, caractérisé en ce que les ions primaires sont produits dans la cellule de mesure (30) par irradiation à distance à l'aide d'un faisceau d'électrons (64) de la substance d'échantillonnage et en ce que l'amplitude du champ alternatif (72) destiné à la résonance ions-cyclotron pour les ions primaires est réglée de telle sorte qu'il résulte une trajectoire circulaire des ions primaires, qui passe par l'endroit (53) où se trouve la substance d'échantillonnage.

7. Procédé suivant la revendication 6, caractérisé en ce que, avant l'excitation de la résonance-cyclotron pour ions secondaires, un champ alternatif (73) destiné aux ions primaires est introduit, par irradiation dont l'amplitude est si grande que les ions primaires atteignent une électrode de captage.

8. Procédé suivant la revendication 7, caractérisé en ce que l'électrode de captage destinée à du courant continu est une électrode de masse (31, 32, 33, 34).

9. Dispositif de mise en œuvre du procédé suivant l'une des revendications précédentes comprenant une unité pour la production d'ions primaires riches en énergie et pour le bombardement d'une substance d'échantillonnage difficilement transformable à l'aide de ces ions primaires pour produire des ions de la substance d'échantillonnage désignés comme ions secondaires et comprenant une cellule de résonance-cyclotron pour ions ou, abrégé, cellule de mesure RCI (30) et des moyens pour exciter et mesurer la résonance des ions secondaires, caractérisé en ce que la cellule de mesure RCI (30) contient un milieu formant les ions primaires, en ce qu'un support d'échantillonnage (53) destiné à la substance d'échantillonnage difficilement transformable est agencé dans la cellule de mesure RCI (30) et en ce que les moyens pour exciter et mesurer la résonance des ions secondaires sont également agencés pour exciter la résonance des ions primaires de telle sorte que de la substance d'échantillonnage agencée sur le support d'échantillonnage (53) est atteinte par les ions primaires excités à résonance dans la cellule de mesure RCI, que de ce fait elle soit elle-même ionisée et que la résonance des ions secondaires est directement mesurable dans la cellule de mesure RCI.

10. Dispositif suivant la revendication 9 ou 10, caractérisé en ce que, à l'extérieur de la cellule de mesure (30), il est prévu un agencement (62, 63) destiné à la production d'un faisceau d'électrons (64) qui est introduit dans la cellule de mesure (30) par des ouvertures (60, 61) de telle manière que sa trajectoire s'étend à une distance présélectionnée du support d'échantillonnage (53).

11. Dispositif suivant la revendication 9 ou 10, caractérisé en ce que la cellule de mesure (30) présente une forme cylindrique circulaire, quatre surfaces en forme de segments d'enveloppe cylindrique (31 à 34) étant prévues qui forment chaque fois un émetteur (31, 32) et respectivement un récepteur (33, 34) qui se trouvent en face l'une de l'autre par paires et qui sont couplées en courant continu à la masse et que, en outre, deux surfaces de recouvrement (35, 36) sont prévues ayant la forme de pièges à ions présentant un potentiel fini ($\pm U_o$).

12. Dispositif suivant la revendication 11, caractérisé en ce que le support d'échantillonnage (53) est fixé sur une tige coulissante (51) qui s'étend parallèlement à l'axe de la cellule de mesure (30) dans celle-ci et qui peut être glissée en direction radiale.

13. Dispositif suivant la revendication 12, caractérisé en ce que le faisceau d'électrons (64) est guidé parallèlement à l'axe de la cellule de mesure (30).

Fig.1

Fig. 2

EP 0 141 059 B1

Fig. 3

Fig. 4

13